(19) Europäisches Patentamt / European Patent Office / Office européen des brevets

(11) **EP 4 413 388 B1**

(12) **EUROPÄISCHE PATENTSCHRIFT**

(45) Veröffentlichungstag und Bekanntmachung des Hinweises auf die Patenterteilung:
**15.10.2025 Patentblatt 2025/42**

(21) Anmeldenummer: **22809085.8**

(22) Anmeldetag: **25.10.2022**

(51) Internationale Patentklassifikation (IPC):
***G01R 31/62*** *(2020.01)*

(52) Gemeinsame Patentklassifikation (CPC):
**G01R 31/62**

(86) Internationale Anmeldenummer:
**PCT/EP2022/079719**

(87) Internationale Veröffentlichungsnummer:
**WO 2023/083599 (19.05.2023 Gazette 2023/20)**

(54) **VERFAHREN ZUM SIMULIEREN EINES TRANSFORMATORS**

METHOD FOR SIMULATING A TRANSFORMER

PROCÉDÉ DE SIMULATION D'UN TRANSFORMATEUR

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **10.11.2021 DE 102021212651**

(43) Veröffentlichungstag der Anmeldung:
**14.08.2024 Patentblatt 2024/33**

(73) Patentinhaber: **Siemens Energy Global GmbH & Co. KG**
**81739 München (DE)**

(72) Erfinder: **RAITH, Johannes**
**8162 Passail (AT)**

(56) Entgegenhaltungen:
EP-A1- 3 716 437        WO-A1-2021/204970
DE-A1- 102019 218 803

# Beschreibung

Die Erfindung betrifft ein Verfahren zum Bestimmen des Betriebszustandes eines in einem Hochspannungsnetz angeordneten Leistungstransformators, der einen mit Isolierflüssigkeit gefüllten Kessel, ein in dem Kessel angeordnetes Aktivteil, das über einen Kern und Abschnitte des Kerns umschließende Wicklungen verfügt, und eine Kühleinheit zum Kühlen der Isolierflüssigkeit aufweist, wobei bei dem Verfahren Messwerte von Sensoren erhalten werden, die in oder an dem jeweiligen Leistungstransformator angeordnet sind, wobei aus den Messwerten ein Flüssigkeitstemperaturmesswert hervorgeht, der einer Messtemperatur der Isolierflüssigkeit entspricht oder aus mehreren Temperaturwerten berechnet wird, wobei wenigstens ein Temperaturwert einer Messtemperatur der Isolierflüssigkeit entspricht, die Messwerte und/oder davon abgeleitete Werte als Eingangswerte einem thermohydraulischen Simulationsmodell zugeführt werden, das thermohydraulischen Simulationsmodell den Betriebszustand des Leistungstransformators ermittelt, indem das thermohydraulische Simulationsmodells ausgangsseitig Zustandsparameter bereitgestellt, die gemeinsam den Betriebszustand des Leistungstransformators darstellen, wobei wenigstens ein Zustandsparameter ein ermittelter Isolierfluidtemperatur-Zustandsparameter ist, der einem für das Isolierfluid berechneten Temperaturwert entspricht.

Eine solches Verfahren ist dem Fachmann aus der Praxis bekannt. So wird üblicherweise ein "digitales Abbild" des Transformatorzustandes simuliert, wobei die physikalischen Zusammenhänge zwischen Temperatur, Feuchtigkeit und die Alterung der verschiedenen Komponenten des Transformators wie Isolierflüssigkeit, Isolierfestkörper, metallische Leiter und dergleichen mittels thermo-hydraulischer Netzwerkmodelle simuliert werden. Mit Hilfe einer solchen Simulation kann beispielsweise die Isolationsalterung eines Transformators berechnet werden, bevor dieser im Elektroenergieversorgungsnetz ausgetauscht werden muss.

Aus der DE 10 2007 026 175 B4 ist ein Verfahren zum Ermitteln der Alterungsrate eines Transformators bekannt geworden. Gemäß dem vorbekannten Verfahren wird die Alterungsrate eines Transformators als Hochspannungsgerät nach dem IEC-Standard 60076-7 berechnet, wobei Sauerstoff- und Feuchteanteil der Isolierflüssigkeit des Transformators berücksichtigt werden.

Aus der EP 3 715 878 A1 ist ein Verfahren zum Bestimmen der Überlastfähigkeit eines Transformators bekannt. Bei dem vorbekannten Verfahren werden einem thermohydraulischem Simulationsmodell Eingangsparameter zur Verfügung gestellt, die von fortwährend erfassten Messwerten abgeleitet werden.

Dokument De102019218803 zeigt ein Verfahren zum Bestimmen der Alterung eines Hochspannungsgeräts, bei dem Messwerte eines Hochspannungsgeräts mit Hilfe von Sensoren, die in oder an dem Hochspannungsgerät angeordnet sind, fortwährend erfasst werden, die Messwerte und/oder davon abgeleitete Werte an ein Alterungsberechnungmodul übertragen werden und das Altertungsberechnungsmodul basierend auf den Messwerten und/oder den davon abgeleiteten Werten eine Alterung des Hochspannungsgeräts ermittelt.

Aus dem ICE-Standard 60076-7 ist bekannt, eine Alterungsrate eines elektrischen Transformators in Abhängigkeit der so genannten Hotspot-Temperatur zu berechnen. Bei der Berechnung wird insbesondere das Isolationspapier der Wicklungen berücksichtigt. Dabei wird näherungsweise angenommen, dass die isolierenden Eigenschaften des Isolierpapiers neben anderen Einflussgrößen von dem Polymerisationsgrad des Isolierpapiers abhängig sind. Die beim Betrieb des Transformators entstehenden Belastungen verändern jedoch den Polymerisationsgrad des Isolierpapiers dahin, so dass die Isolationsfähigkeit des Wicklungspapiers mit zunehmender Lebensdauer abnimmt und schließlich unzureichend wird, sodass der Transformator das Ende seiner Lebensdauer erreicht.

Die Hot-Spot- oder Heißpunkttemperatur kann aus Messungen der Temperatur des Isolierfluids und aus der Messung des Wicklungsstromes ermittelt werden. Wie bereits weiter oben ausgeführt ist, kann aus der Hot-Spot Temperatur die Lebensdauer des Transformators ermittelt werden.

Bei den bisher bekannten Verfahren werden Wettereinflüsse in Gestalt einer Umgebungstemperatur dem Simulationsmodell als Eingangsparameter zur Verfügung gestellt. Dies ist jedoch in keiner Weise ausreichend da Wetterbedingungen wie Wind und Regen das Temperaturverhalten von Transformatoren im Anlagenbetrieb signifikant beeinflussen mit einer Änderung des Feuchtigkeits- und Alterungszustandes seiner Komponenten im Gefolge. Eine unmittelbare Berücksichtigung von Wind und Regen im Simulationsmodell ist aufgrund der komplexen Zusammenhänge zwischen Wettereinfluss und thermischem Verhalten des Transformators bislang nicht möglich. Es wären einfach zu viele Einflussgrößen wie beispielsweise Aufstellungsort, Änderung der Windrichtung, Windgeschwindigkeit, Regenmenge und dergleichen zu berücksichtigen. Ferner muss sichergestellt bleiben, dass die thermo-hydraulischen Zusammenhänge in dem Transformatormodell, die dort in Gestalt von Differentialgleichungen eingebettet sind, erhalten bleiben. Deshalb ist auch die Verwendung von direkten Temperaturmesswerten des Isolierfluids in thermo-hydraulischen Transformatoralterungsmodellen nicht zielführend.

Aufgabe der Erfindung ist es, ein Verfahren der eingangs genannten Art bereit zu stellen, das die Berücksichtigung von Wettereinflüssen in der Simulation unter Aufrechterhaltung der physikalischen Zusammenhänge in einem thermohydraulischen Transformatormodell ermöglicht.

Diese Aufgabe wird dadurch gelöst, dass dem thermohydraulischen Simulationsmodell eingangsseitig wenigsten eine Regelstrecke vorgeschaltet ist, die eine Regelabweichung ermittelt, die aus der Differenz zwischen Flüssigkeitstemperaturmesswert und dem Isolierfluidtemperatur-Zustandsparameter gebildet wird.

Das erfindungsgemäß bereitgestellte Verfahren ermöglicht die Berücksichtigung von Temperaturänderungen im Transformator, die auf Grund von Wettereinflüssen wie Wind oder Regen entstehen, ohne dass zusätzliche Messungen notwendig werden. Im Rahmen der Erfindung kann auf eine zusätzliche Wetter Sensorik vollständig verzichtet werden.

Wettereinflüsse wie Wind und Regen wirken auf unterschiedliche physikalische Parameter der Kühlanlage ein. So werden beispielsweise die Wärmeübergangszahl der Kühlanlage, der Öldurchfluss (hydraulische Widerstände) oder dergleichen durch Wettereinflüsse verändert. Die Änderung dieser physikalischen Parameter durch den Wettereinfluss kann im Rahmen der Erfindung durch den Vergleich verschiedener Mess- und Simulationstemperaturen ermittelt werden. Mit einem entsprechenden Regler kann dann die Regelabweichung gebildet werden. Auf diese Weise werden die Temperaturabweichungen zwischen Modell und Realität minimiert. Alle physikalischen Zusammenhänge im Modell bleiben im Rahmen der Erfindung erhalten.

Im Rahmen der Erfindung kann auch auf ein bereits eingeführte Simulationsmodelle unter Aufrechterhaltung der physikalischen Zusammenhänge zurückgegriffen werden. Eingeführte und optimierte hydraulische Zusammenhänge zwischen Temperatur-, Feuchte- und Alterungszustand können weiterhin genutzt werden. Mit anderen Worten greift die Erfindung in das Gleichungssystem des Modells mit den entsprechenden physikalischen Parametern ein und ermöglicht so eine Mischung von Mess- und Rechenwerten im physikalischen Modell.

Zweckmäßigerweise wird die Regelabweichung jeder Reglerstrecke durch einen Differenzbildner ermittelt. Differenzbilder sind in der Regelungstechnik weit verbreitet und kostengünstig im Markt erhältlich.

Vorteilhafterweise wird jede Regelabweichung einem Regler zugeführt wird, dessen ausgangsseitig bereit gestellten Steuergrößen dem thermohydraulischen Simulationsmodell zugeführt werden.

Gemäß einer diesbezüglich zweckmäßigen Weiterentwicklung werden die Steuergrößen dem thermohydraulischen Simulationsprogramm über einen Aktuator zugeführt, auf den die Steuergrößen eingangsseitig übertragen werden, wobei der Aktuator anhand der Steuergrößen einen Stellgrößenparameter ermittelt, der dem thermohydraulischen Simulationsmodell eingangsseitig zugeführt wird.

Gemäß einer diesbezüglich zweckmäßigen Weiterentwicklung umfassen die Zustandsparameter einen Parameter, der auf Grundlage eines durch eine der Wicklungen des jeweiligen Transformators (9) fließenden Stromes ermittelt wurde.

Bei einer besonders bevorzugten Variante der Erfindung werden dem thermohydraulischen Simulationsmodell eingangsseitig zwei Regelstrecken vorgeschaltet. Die Nutzung von zwei Regelstrecken erhöht gegenüber einer Variante der Erfindung mit nur einer Regelstrecke die Genauigkeit mit der Wettereinflüsse berücksichtigt werden können. Selbstverständlich können im Rahmen der Erfindung auch mehr als zwei Regelstrecken eingesetzt werden.

Zweckmäßigerweise wird zumindest ein Flüssigkeitstemperaturmesswert $\Delta\Theta_{ao,meas}$ aus der Differenz zwischen einem mittleren Isolierflüssigkeit-Temperaturwert $\Theta_{ave}$ und einem Umgebungstemperaturmesswert $T_{amb}$ nach $\Delta\Theta_{ao,meas} = \Theta_{ave} - T_{amb}$ gebildet, wobei der mittlere Isolierflüssigkeit-Temperaturwert $\Theta_{ave}$ aus einem im oberen Bereich des Kessels erfassten Temperaturmesswert $\Theta_{top}$ und einem im unteren Bereich des Kessels erfassten Temperaturmesswert $\Theta_{bot}$ gemäß $\Theta_{ave} = (\Theta t_{op} + \Theta_{bot})/2$ ermittelt wird.

Bei einer weiteren Variante der Erfindung ein Flüssigkeitstemperaturmesswert aus der Differenz $D_{o,meas}$ zwischen einem im oberen Bereich des Kessels erfassten Temperaturmesswert $\Theta_{top}$ und einem im unteren Bereich des Kessels erfassten Temperaturmesswert $\Theta_{bot}$ gemäß $D_{o,meas} = \Theta_{top} - \Theta_{top}$ hergeleitet.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkende Bauteile verweisen und wobei

Figur 1    einen Transformator, der von dem erfindungsgemäßen Verfahren simuliert wird, und

Figur 2    ein Ausführungsbeispiel des erfindungsgemäßen Verfahrens schematisch verdeutlichen.

Transformatoren sind Schlüsselkomponenten elektrischer Versorgungsnetze. Der Ausfall eines Transformators kann zu extremen Einbußen und sogar zu Netzausfällen führen. Transformatoren werden daher gut überwacht. Um die Alterung eines Transformators festzustellen, wird beispielsweise eine "Fieberkurve" des Transformators aufgenommen, um auf diese Weise Informationen über die aktuelle Belastung und Lebensdauer zu gewinnen. Die Alterung eines Transformators kann unter anderem durch einen so genannten digitalen Zwilling oder mit anderen Worten durch ein thermohydraulisches Simulationsmodell berechnet werden.

Aus dem ICE-Standard 60076-7 ist bekannt, eine Alterungsrate eines elektrischen Transformators in Abhängigkeit der so genannten Hotspot-Temperatur zu berechnen. Bei der Berechnung wird insbesondere das Isolationspapier der Wicklungen berücksichtigt. Dabei wird näherungsweise angenommen, dass die isolierenden Eigenschaften des Isolierpapiers neben anderen Einflussgrößen von dem Polymerisationsgrad des Isolierpapiers abhängig sind. Die beim Betrieb des Transformators entstehenden Belastungen verändern jedoch den Polymerisationsgrad des Isolierpapiers dahin, dass die Isolationsfähigkeit des Wicklungspapiers mit zunehmender Lebensdauer abnimmt und schließlich unzureichend wird, sodass der Transformator das Ende seiner Lebensdauer erreicht.

Die Hot-Spot- oder Heißpunkttemperatur kann aus Messungen der Temperatur des Isolierfluids und aus der Messung des Wicklungsstromes ermittelt werden. Wie bereits weiter oben ausgeführt ist, kann aus der Hot-Spot Temperatur die Lebensdauer des Transformators ermittelt werden.

Die Erfindung beruht auch auf der Idee, dass die Temperatur der Isolierflüssigkeit und der Wicklungsstrom ohnehin fortwährend beobachtet werden. Es ist im Hinblick auf die Digitalisierung darüber hinaus wahrscheinlich, dass diese Messgrö-ßen oder davon abgeleitete Daten von dem jeweiligen Transformator zu einer Datenverarbeitungs-Cloud übertragen werden, wobei die Datenverarbeitungs-Cloud aus dem ihr zur Verfügung gestellten Daten fortwährend die Lebensdauer des besagten Transformators ermittelt und diese Größe, beispielsweise einem thermohydraulischen Simulationsmodell, zur Verfügung stellen kann.

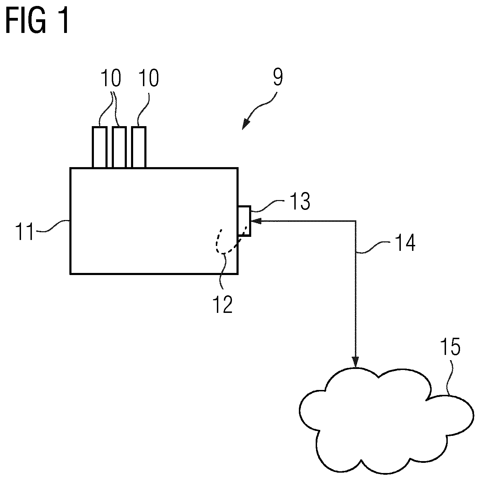

Figur 1 zeigt einen schematisch dargestellten Transformator 9 mit seinen drei Durchführungen 10, die an einem Kessel 11 des Transformators 9 abgestützt sind. An ihrem vom Kessel 11 abgewandten Ende, verfügen die Durchführungen 10 über einen so genannten Freiluftanschluss zum Anschluss einer luftisolierten Hochspannungsleitung eines Energieversorgungsnetzes. Jede Durchführung 10 verfügt über einen inneren Hochspannungsleiter, der sich durch einen hohlen Isolator erstreckt. Dabei durchgreifen der Isolator und der Hochspannungsleiter die obere Wandung des Kessels 11 des Transformators 9 und erstrecken sich mit ihrem freien Ende in mit Isolierflüssigkeit gefüllten Innenraum des Kessels 11 hinein. Die Hochspannungsleiter jeder Durchführung 10 kann so mit der jeweiligen Oberspannungswicklung des Transformators 9 verbunden werden. Jede Hochspannungswicklung ist konzentrisch zu einer Unterspannungswicklung angeordnet, durch die sich ein Schenkel eines magnetisierbaren Kerns erstreckt. Oberspannungs- und Unterspannungswicklungen sind so induktiv miteinander gekoppelt.

Der Kessel 11 der Transformators 9 ist mit einer Isolierflüssigkeit befüllt, die zur Isolierung und zur Kühlung der beim Betrieb auf Hochspannung liegenden Wicklungen und des Kerns dient. Der Transformator weist ferner eine Kühleinheit auf, die figürlich jedoch nicht dargestellt ist.

Der Transformator 9 ist mit Temperatursensoren bestückt, die im Inneren des Kessels 11 zur Erfassung der Temperatur der Isolierflüssigkeit angeordnet sind und figürlich daher nicht dargestellt sind. Jeder Temperatursensor ist über eine Nahbereichskommunikationsverbindung 12 mit einer an dem Transformator 9 befestigten Kommunikationseinheit 13 verbunden, wobei die Nahbereichs-Kommunikationsverbindung 12 in diesem Fall als Kabel ausgeführt ist. Die Kommunikationseinheit 13 ist wiederum über eine Fernbereichs-Kommunikationsverbindung 14 mit einer Datenverarbeitungs-Cloud 15 verbunden.

Die von den Temperatursensoren erfassen Temperaturmesswerte werden über die Nahbereichs-Kommunikationsverbindung 12 zur Kommunikationseinheit 13 gesendet. Diese überträgt die Temperaturmesswerte über die Fernbereich-Kommunikationsverbindung 14 zur Datenverarbeitungs-Cloud 15. Die Datenverarbeitungs-Cloud 15 verfügt über ein thermohydraulisches Lastvorhersagemodel, das auch als digitaler Zwilling bezeichnet werden kann. Es berechnet beispielsweise eine verbrauchte Lebensdauer anhand der erfassten Temperaturmesswerte sowie der erfassten Wicklungsströme nach dem oben genannten Standard. Auf diese Art und Weise wird der Lebensdauerverbrauch des Transformators 9 fortwährend ermittelt und steht bei Bedarf zur Verfügung.

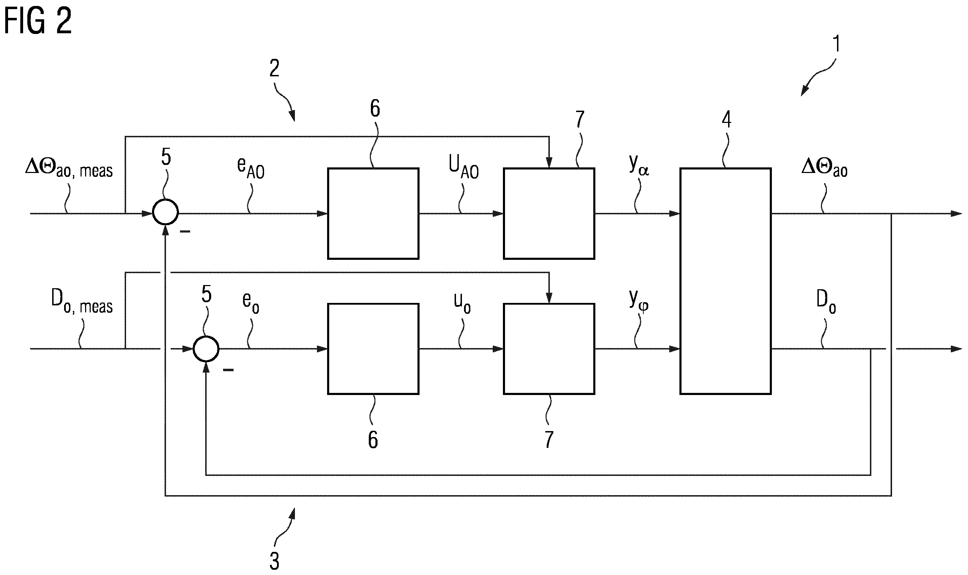

Das erfindungsgemäße Verfahren 1 ist schematisch in Figur 2 dargestellt. Es sind zwei Regelstrecken 2 und 3 erkennbar, die einem thermohydraulischen Simulationsmodell eingangsseitig vorgeschaltet sind. Es ist erkennbar, dass jede Regelstrecke eine Differenzbildner 5, einen Regler 6 und einen Aktuator 7 aufweist. Der in Figur 1 gezeigte Transformator weist dort figürlich nicht dargestellte Sensoren auf, die in einem oberen und einem unteren Bereich des Kessels 11 jeweils eine Temperatur der Isolierflüssigkeit erfassen. Die Temperatursensoren können die Temperatur der Isolierflüssigkeit abweichend davon auch in einem oberen Zulauf einer Kühleinheit und in einem untern Ablauf der besagten Kühleinheit erfassen. Die Kühleinheit ist über den oberen Zulauf und den unteren Ablauf mit dem Kessel 11 des Transformators verbunden. Heiße Isolierflüssigkeit, die beim Betrieb des Transformators entsteht, steigt im Kessel 11 nach oben und erreicht über den Zulauf die Kühleinheit, wo die Isolierflüssigkeit wieder abgekühlt wird. Die abgekühlte und somit dichtere Isolierflüssigkeit gelangt dann über den Ablauf wieder in den Kessel.

Die von dem im oberen Bereich des Kessels 11 angeordneten Sensor bereitgestellten Ausgangssignale werden unter Gewinnung von Abtastwerten abgetastet und diese dann durch einen nicht gezeigten A/D-Wandler digitalisiert. Entsprechendes gilt für den im unteren Bereich des Kessels 11 angeordneten Sensor. Die digitalen Temperaturmesswerte des oberen Sensors sind im Folgenden mit $\Theta_{top}$ und diejenigen des im unteren Bereich des Kessels angeordneten Sensor mit $\Theta_{bot}$ bezeichnet. Mit $T_{amb}$ sind Temperaturwerte bezeichnet, die der Temperatur der Kühlatmosphäre entsprechen.

Aus diesen Messwerten wird für die obere Regelstrecke 3 ein Flüssigkeitstemperaturmesswert $\Delta\Theta_{ao,meas}$ gemäß

$$\Delta\Theta_{ao,meas} = \Theta_{ave} - T_{amb}$$

berechnet, wobei $\Theta_{ave}$ hier als mittlerer Isolierflüssigkeit-Temperaturwert bezeichnet wird, der aus den oben eingeführten direkten Messwerten gemäß $\Theta_{ave} = (\Theta_{top} + \Theta_{bot})/2$ hervorgeht. Flüssigkeitstemperaturmesswert der unteren Regelstrecke 4 ist $D_{o,meas}$, ein Temperaturwert der Isolierflüssigkeit, der wie folgt aus den Messwerten berechnet werden kann:

$$D_{o,meas} = \Theta_{top} - \Theta_{bot} \cdot \text{~}$$

Die Flüssigkeitstemperaturmesswerte $\Delta\Theta_{ao,meas}$ und $D_{o,meas}$ werden jeweils einem Differenzbildner zugeführt, der die Differenz zwischen dem aus Messungen hervorgehenden Flüssigkeitstemperaturmesswert und dem von dem thermohydraulischen Simulationsmodell simulierten Isolierflüssigkeitstemperatur-Zustandsparameter $\Delta\Theta_{ao}$ bzw. $D_o$ unter Gewinnung der Regelabweichungen $e_{AO}$ und $e_O$ bildet. Die besagten Regelabweichungen werden jeweils einem Regler 6 eingangsseitig zugeführt, der ausgangsseitig eine Steuergröße für die mittlere Isolierflüssigkeitserwärmung $U_{AO}$ beziehungsweise eine Steuergröße für die Flüssigkeitstemperaturspreizung $U_o$ bereitstellt. Diese Steuergrößen werden jeweils einem Aktuator zugeführt, der anhand der Steuergrüßen und der entsprechenden Messwerte den Wert einer Stellgröße $y_\alpha$ beziehungsweise $y_\varphi$ für die jeweilige Regelstrecke 3 und 4 erzeugt. Die Stellgrößen $y_\alpha$ beziehungsweise $y_\varphi$ werden schließlich dem thermohydraulischen Simulationsmodell 4 eingangsseitig zugeführt, das dann die Isolierflüssigkeitstemperatur-Zustandsparameter $\Delta\Theta_{ao}$ bzw. $D_o$. simuliert.

Die Regelstrecken 3, 4 wirken einer größer werdenden Abweichung der simulierten Isolierflüssigkeitstemperatur-Zustandsparameter von ihrem Pendant in der realen Welt, also den Flüssigkeitstemperaturmesswerte $\Delta\Theta_{ao,meas}$ und $D_{o,meas}$, entgegen.

**Patentansprüche**

1. Verfahren (1) zum Bestimmen des Betriebszustandes eines in einem Hochspannungsnetz angeordneten Transformators (9), der einen mit Isolierflüssigkeit gefüllten Kessel (11), ein in dem Kessel (11) angeordnetes Aktivteil, das über einen Kern und Abschnitte des Kerns umschließende Wicklungen verfügt, und eine Kühleinheit zum Kühlen der Isolierflüssigkeit aufweist, wobei bei dem Verfahren (1):

   - Messwerte von Sensoren erhalten werden, die in oder an dem jeweiligen Leistungstransformator angeordnet sind, wobei aus den Messwerten wenigstens ein Flüssigkeitstemperaturmesswert ($\Delta\Theta_{ao,meas}$, $D_{o,meas}$) hervorgeht, der einer Messtemperatur der Isolierflüssigkeit entspricht oder aus mehreren Temperaturwerten ($T_{amb}$) berechnet wird, wobei wenigstens ein Temperarturwert einer Messtemperatur der Isolierflüssigkeit ($\Theta_{top}$, $\Theta_{Bot}$)entspricht,
   - die Messwerte und/oder davon abgeleitete Werte als Eingangswerte einem thermohydraulischen Simulationsmodell (4) zugeführt werden,
   - das thermohydraulischen Simulationsmodell (4) den Betriebszustand des Transformators (9) ermittelt, indem das thermohydraulische Simulationsmodells (4) ausgangsseitig simulierte Zustandsparameter bereitgestellt, die gemeinsam den Betriebszustand des Transformators darstellen, wobei wenigstens ein Zustandsparameter ein Isolierflüssigkeitstemperatur-Zustandsparameter ist, der einem für die Isolierflüssigkeit simulierten Temperaturwert entspricht,

   **dadurch gekennzeichnet, dass**
   dem thermohydraulischen Simulationsmodell (4) eingangsseitig wenigsten eine Regelstrecke (3, 4) vorgeschaltet ist, die eine Regelabweichung ($e_{AO}$, $e_O$) ermittelt, die aus der Differenz zwischen Flüssigkeitstemperarturmesswerten ($\Delta\Theta_{ao,meas}$, $D_{o,meas}$) und dem entsprechenden simulierten Isolierfluidtemperatur-Zustandsparameter ($\Delta\Theta_{ao}$, $D_o$) gebildet wird.

2. Verfahren (1) nach Anspruch 1,
   **dadurch gekennzeichnet, dass** die Regelabweichung ($e_{AO}$, $e_O$) bei jeder Regelungsstrecke durch einen Differenzbilder (5) ermittelt wird.

3. Verfahren (1) nach einem der vorhergehenden Ansprüche, **dadurch gekennzeichnet, dass** jede Regelabweichung ($e_{AO}$, $e_O$) einem Regler (6) zugeführt wird, dessen ausgangsseitig bereit gestellten Steuergrößen ($u_{AO}$, $u_o$) dem thermohydraulischen Simulationsmodell (4) zugeführt werden.

4. Verfahren (1) nach Anspruch 3,
   **dadurch gekennzeichnet, dass** die Steuergrößen ($u_{AO}$, $u_o$) dem thermohydraulischen Simulationsprogramm (4) über einen Aktuator (7) zugeführt werden, der die Steuergrößen eingangsseitig erhält, wobei der Aktuator (7) anhand der Steuergrößen ($u_{AO}$, $u_o$) eine Stellgröße ($y_\alpha$, $y_\varphi$) ermittelt, der dem thermohydraulischen Simulationsmodell (4) eingangsseitig zugeführt wird.

5. Verfahren (1) nach einem der vorhergehenden Ansprüche, **dadurch gekennzeichnet, dass** die Zustandsparameter einen Parameter umfassen, der auf Grundlage eines durch eine der Wicklungen des jeweiligen Transformators (9) fließenden Stromes ermittelt wurde.

6. Verfahren (1) nach einem der vorhergehenden Ansprüche, **dadurch gekennzeichnet, dass** dem thermohydraulischen Simulationsmodell (4) eingangsseitig zwei Regelstrecken (3, 4) vorgeschaltet sind.

7. Verfahren (1) nach einem der vorhergehenden Ansprüche, **dadurch gekennzeichnet, dass** zumindest ein Flüssigkeitstemperaturmesswert $\Delta\Theta_{ao}$ aus der Differenz zwischen einem mittleren Isolierflüssigkeit-Temperaturwert $\Theta_{ave}$ und einem Umgebungstemperaturmesswert $T_{amb}$ nach $\Delta\Theta_{ao,meas} = \Theta_{ave} - T_{amb}$ gebildet wird, wobei der mittlere Isolierflüssigkeit-Temperaturwert $\Theta_{ave}$ aus einem im oberen Bereich des Kessels erfassten Temperaturmesswert $\Theta_{top}$ und einem im unteren Bereich des Kessels erfassten Temperaturmesswert $\Theta_{bot}$ gemäß $\Theta_{ave} = (\Theta_{top} + \Theta_{bot})/2$ ermittelt wird.

8. Verfahren (1) nach einem der vorhergehenden Ansprüche, **dadurch gekennzeichnet, dass** ein Flüssigkeitstemperaturmesswert aus der Differenz $D_{o,meas}$ zwischen einem im oberen Bereich des Kessels erfassten Temperaturmesswert $\Theta_{top}$ einem im unteren Bereich des Kessels erfassten Temperaturmesswert $\Theta_{bot}$ gemäß $D_{o,meas} = \Theta_{top} - \Theta_{bot}$ hergeleitet wird.

## Claims

1. Method (1) for determining the operating state of a transformer (9) which is arranged in a high-voltage grid, said transformer comprising a tank (11) which is filled with insulating liquid, an active part which is arranged in the tank (11) and has windings which enclose a core and sections of the core, and a cooling unit for cooling the insulating liquid, wherein, in the method (1):

    - measurement values are obtained from sensors which are arranged in or on the respective power transformer, wherein the measurement values are used to obtain at least one liquid temperature measurement value ($\Delta\Theta_{ao,meas}$, $D_{o,meas}$) which corresponds to a measurement temperature of the insulating liquid or is calculated from a plurality of temperature values ($T_{amb}$), wherein at least one temperature value corresponds to a measurement temperature of the insulating liquid ($\Theta_{top}$, $\Theta_{bot}$),
    - the measurement values and/or values derived therefrom are supplied to a thermohydraulic simulation model (4) as input values,
    - the thermohydraulic simulation model (4) ascertains the operating state of the transformer (9) by virtue of the thermohydraulic simulation model (4) providing, on the output side, simulated state parameters which together represent the operating state of the transformer, wherein at least one state parameter is an insulating liquid temperature state parameter which corresponds to a temperature value which is simulated for the insulating liquid,

    **characterized in that**
    at least one controlled system (3, 4) is connected upstream of the input side of the thermohydraulic simulation model (4), which controlled system ascertains a control deviation ($e_{AO}$, $e_O$) which is formed from the difference between liquid temperature measurement values ($\Delta\Theta_{ao,meas}$, $D_{o,meas}$) and the corresponding simulated insulating fluid temperature state parameter ($\Delta\Theta_{ao}$, $D_o$).

2. Method (1) according to Claim 1,
    **characterized in that**
    the control deviation ($e_{AO}$, $e_O$) is ascertained in each controlled system by a difference former (5).

3. Method (1) according to either of the preceding claims, **characterized in that**
    each control deviation ($e_{AO}$, $e_O$) is supplied to a controller (6), the control variables ($u_{AO}$, $u_o$) of which, provided on the output side, are supplied to the thermohydraulic simulation model (4).

4. Method (1) according to Claim 3,
    **characterized in that**
    the control variables ($u_{AO}$, $u_o$) are supplied to the thermohydraulic simulation program (4) by means of an actuator (7) which receives the control variables on the input side, wherein the actuator (7) takes the control variables ($u_{AO}$, $u_o$) as a basis for ascertaining a manipulated variable ($y_\alpha$, $y_\varphi$) which is supplied to the input side of the thermohydraulic simulation model (4).

5. Method (1) according to any one of the preceding claims, **characterized in that**
    the state parameters include a parameter which has been ascertained on the basis of a current flowing through one of the windings of the respective transformer (9).

6. Method (1) according to any one of the preceding claims, **characterized in that**
    two controlled systems (3, 4) are connected upstream of the input side of the thermohydraulic simulation model (4).

7. Method (1) according to any one of the preceding claims, **characterized in that**
    at least one liquid temperature measurement value $\Delta\Theta_{ao}$ is formed from the difference between an average insulating liquid temperature value $\Theta_{ave}$ and an ambient temperature measurement value $T_{amb}$ ac-

cording to $\Delta\Theta_{ao,meas} = \Theta_{ave} - T_{amb}$, wherein the average insulating liquid temperature value $\Theta_{ave}$ is ascertained from a temperature measurement value $\Theta_{top}$ measured in the top region of the tank and a temperature measurement value $\Theta_{bot}$ measured in the bottom region of the tank according to $\Theta_{ave} = (\Theta_{top} + \Theta_{bot})/2$.

8. Method (1) according to any one of the preceding claims, **characterized in that**
a liquid temperature measurement value is derived from the difference $D_{o,meas}$ between a temperature measurement value $\Theta_{top}$ measured in the top region of the tank and a temperature measurement value $\Theta_{bot}$ measured in the bottom region of the tank according to $D_{o,meas} = \Theta_{top} - \Theta_{bot}$.

**Revendications**

1. Procédé (1) de détermination de l'état de fonctionnement d'un transformateur (9), qui est monté dans un réseau de haute tension et qui a une cuve (11) remplie d'un liquide isolant, une partie active, qui est disposée dans la cuve (11) et qui dispose d'un noyau et d'enroulements entourant des segments du noyau, et une unité de refroidissement pour le refroidissement du liquide isolant, dans lequel dans le procédé (1) :

- on reçoit des valeurs de mesure de capteurs, qui sont montés dans ou sur le transformateur de puissance respectif, dans lequel il ressort des valeurs de mesure au moins une valeur ($\Delta\Theta_{ao,\ meas}$, $D_{o,\ meas}$) de mesure de température de liquide, qui correspond à une température de mesure du liquide isolant ou qui est calculée à partir de plusieurs valeurs ($T_{amb}$) de température, dans lequel au moins une valeur de température correspond à une température de mesure du liquide ($\Theta_{top}$, $\Theta_{bot}$) isolant,
- on envoie les valeurs de mesure et/ou des valeurs, qui s'en déduisent, comme valeurs d'entrée à un modèle (4) de simulation thermohydraulique,
- le module (4) de simulation thermohydraulique détermine l'état de fonctionnement du transformateur (9), par le fait que le modèle (4) de simulation thermohydraulique donne des paramètres d'état simulés en sortie, qui représentent conjointement l'état de fonctionnement du transformateur, dans lequel au moins un paramètre d'état est un paramètre d'état de température de liquide isolant, qui correspond à une valeur de température simulée pour le liquide isolant,

**caractérisé en ce que,**

en amont du modèle (4) de simulation thermohydraulique est monté du côté de l'entrée au moins un système (3, 4) asservi, qui détermine un écart ($e_{AO}$, $e_O$) de réglage, formé à partir de la différence entre des valeurs ($\Delta\Theta_{ao,\ meas}$, $D_{o,\ meas}$) de mesure de température de liquide et le paramètre ($\Delta\Theta_{ao}$, $D_o$) d'état de température du fluide isolant simulé correspondant.

2. Procédé (1) suivant la revendication 1, **caractérisé en ce que** l'
on détermine l'écart ($e_{AO}$, $e_O$) de réglage dans chaque système asservi par un formeur (5) de différences.

3. Procédé (1) suivant l'une des revendications précédentes, **caractérisé en ce que** l'
on envoie chaque écart ($e_{AO}$, $e_O$) de réglage à un régleur (6), dont on envoie les grandeurs ($u_{AO}$, $u_O$) de commande déjà réglées du côté de la sortie au modèle (4) de simulation thermohydraulique.

4. Procédé (1) suivant la revendication 3, **caractérisé en ce que** l'
on envoie les grandeurs ($u_{AO}$, $u_O$) de commande au programme (4) de simulation thermohydraulique en passant par un actionneur (7), qui reçoit du côté de l'entrée les grandeurs de commande, dans lequel l'actionneur (7) détermine, à l'aide des grandeurs ($u_{AO}$, $u_O$) de commande, une grandeur ($y_\alpha$, $y_\varphi$) de réglage, qu'il envoie du côté de l'entrée au modèle (4) de simulation thermohydraulique.

5. Procédé (1) suivant l'une des revendications précédentes, **caractérisé en ce que**
les paramètres d'état comprennent un paramètre, qui a été déterminé sur la base d'un courant électrique passant dans l'un des enroulements du transformateur (9) respectif.

6. Procédé (1) suivant l'une des revendications précédentes, **caractérisé en ce que**
deux systèmes (3, 4) asservis sont montés en amont du côté de l'entrée du modèle (4) de simulation thermohydraulique.

7. Procédé (1) suivant l'une des revendications précédentes, **caractérisé en ce que** l'
on forme au moins une valeur $\Delta\Theta_{ao}$ de mesure de température de liquide à partir de la différence entre une valeur $\Theta_{ave}$ de température de liquide isolant moyenne et une valeur $T_{amb}$ de mesure de température ambiante suivant $\Delta\Theta_{ao,\ meas} = \Theta_{ave} - T_{amb}$, dans lequel on détermine la valeur $\Theta_{ave}$ de température de liquide isolant moyenne à partir d'une valeur $\Theta_{top}$ de mesure de température détectée dans la partie supérieure de la cuve et d'une valeur $\Theta_{bot}$ de mesure de température détectée dans la partie inférieure de la cuve suivant $\Theta_{ave} = (\Theta_{top} + \Theta_{bot})/2$.

8.  Procédé (1) suivant l'une des revendications précédentes, **caractérisé en ce que** l'on déduit une valeur de mesure de température de liquide de la différence $D_{o, meas}$ entre une valeur $\Theta_{top}$ de mesure de température détectée dans la partie supérieure de la cuve et une valeur $\Theta_{bot}$ de mesure de température détectée dans la partie inférieure de la cuve suivant $D_{o, meas} = \Theta_{top} - \Theta_{bot}$.

FIG 1

FIG 2

$\Delta\Theta_{a0}$

$D_0$

$y_\alpha$

$y_\varphi$

$U_{A0}$

$u_0$

$e_{A0}$

$e_0$

$\Delta\Theta_{a0,\,meas}$

$D_{0,\,meas}$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007026175 B4
- EP 3715878 A1

- DE 102019218803